# EUROPEAN PATENT APPLICATION

(11) **EP 2 843 755 A1**
(43) Date of publication of application: **04.03.2015**
(21) Application number: 13781625.2
(22) Date of filing: 18.02.2013
(51) Int. Cl.: H01M 14/00, H01L 31/04, H01M 2/20

(54) **SOLAR CELL MODULE AND METHOD FOR CONNECTING SAME**

(30) Priority: 26.04.2012 JP 2012101673
(71) Applicant: Nissha Printing Co., Ltd., Kyoto-shi, Kyoto 604-8551 (JP)
(72) Inventor: YAMAGUCHI, Yoichi, Kyoto-shi Kyoto 604-8551 (JP); OGAYA, Shinji, Kyoto-shi Kyoto 604-8551 (JP); TSUDA, Hayato, Kyoto-shi Kyoto 604-8551 (JP)
(74) Representative: Global IP Europe Patentanwaltskanzlei
(86) International application number: PCT/JP2013/053841
(87) International publication number: WO 2013/161355

(57) **Abstract**

[Problem] To provide a solar cell module having excellent conversion efficiency by lowering the electric resistance between the solar cells in a solar cell module in which at least two dye-sensitized solar cells are coupled with each other.

[Solution] The solar cell module 10 includes metallic plate or metallic tape 52, as the conductive member which does not have adhesiveness, located so as to keep in contact with the first current collecting line 35 as the exposed portion of the first conductive layer of the first solar cell 20 and the second current collecting line 45 as the exposed portion of the second conductive layer of the second solar cell 20, and the insulation tape 53 as the coupling member that couples the first solar cell 20 and the second solar cell 20 such that the metallic plate or metallic tape 52 keeps in contact with them.

## Description

### TECHNICAL FIELD

The present invention relates to a solar cell module and its coupling method, and particularly to a dye-sensitized solar cell module and its connecting method.

### BACKGROUND ART

Conventionally at least two of dye-sensitized solar cells are connected with each other in order to form a solar cell module. As this kind of examples, for example, a method of coupling the solar cells as disclosed in Patent Document 1 has been known. In Fig. 2 of Patent Document 1, a solar cell module is shown. The solar cell module of Patent Document 1 includes one solar cell having a conductive film exposed outside on a transparent substrate side, another solar cell having a conductive film exposed outside on a counter substrate side, and a conductive adhesive coupling the conductive films, which are stacked with each other in the vertical direction, to couple the solar cell module.

Generally, the conductive adhesive is formed of a conductive filler and resinous principle at a certain ratio in order to balance the conductivity and the adhesiveness. If the ratio of the conductive filler in the conductive adhesive is increased, the electric resistance becomes lower. In contrast, if the ratio of the resinous principle is increased, the bonding strength is improved.

### PRIOR ARTS

### PATENT DOCUMENT

Patent Document 1: Japanese Patent Publication 2007-265635

### DISCLOSURE OF THE INVENTION

### PROBLEMS TO BE SOLVED BY THE INVENTION

If the conductive adhesive is employed as in the above-described coupling method of the solar cell module, the electric resistance between the solar cells might be increased due to the resinous principle in the conductive adhesive.

In addition, since the electric resistance of the conductive adhesive may change due to its thickness, if the thickness of the conductive adhesive are varied, it is assumed that the electric resistance may vary according to the solar cell modules.

In addition, the coupling method using the conductive adhesive requires processes of pasting and curing the conductive adhesive, so that there are concerns over the possibility of increasing the number of the processes.

It is an object of the present invention to provide a solar cell module having excellent conversion efficiency by lowering the electric resistance between the solar cells in a solar cell module in which at least dye-sensitized solar cells are coupled with each other. It is another object of the present invention to provide a method of coupling such a solar cell module.

### SOLUTIONS TO THE PROBLEMS

In order to achieve the above-described object, the first invention is a solar cell module comprising at least two dye-sensitized solar cells coupled with each other. Each of the solar cells comprises:
a photoelectrode substrate including a first base member, and a first conductive layer and a photoelectrode layer sequentially formed on one surface of the photoelectrode substrate;
a counter electrode substrate including a second base member and a second conductive layer formed on one surface of the second base member, the counter electrode substrate being located with a certain space from the photoelectrode substrate so as to face the surface on which the first conductive layer is formed, and the counter electrode substrate being located to be displaced from the photoelectrode substrate such that an exposed portion of the first conductive layer and an exposed portion of the second conductive layer are defined; and
a charge conveyance layer provided in the certain space.

The solar cell module further comprises:
a conductive member which does not have adhesiveness, the conductive member being located so as to keep in contact with the exposed portion of the first conductive layer of a first solar cell and the exposed portion of the second conductive layer of a second solar cell; and
a coupling member coupling the first solar cell with the second solar cell such that the conductive member keeps in contact with the exposed portions.

According to the above-described configuration, since it is unnecessary to use conductive adhesive for coupling the solar cell module, the electric resistance between the solar cells is lowered. In addition, since the processes of pasting and curing the conductive adhesive becomes unnecessary, the number of the processes is decreased.

The second invention is a solar cell module according to the structure of the first invention, wherein the first conductive layer includes a first conductive film, and a first current collecting line formed on a portion of the first conducive film where the photoelectrode layer is not formed, and the exposed portion of the first conductive layer is made of the first current collecting line.

According to the above-described configuration, since electric power can be output from the first current collecting line, it is possible to reduce the lowering of power generation efficiency due to the electric resistance of the first conductive film.

The third invention is a solar cell module according to the configuration of the first or the second invention, wherein the second conductive layer includes a second conductive film, and a second current collecting line formed on the second conductive layer, and the exposed portion of the second conductive layer is made of the second current collecting line.

According to the above-described configuration, since the electric power can be output from the second current collecting line, it is possible to reduce the lowering of power generation efficiency due to the electric resistance of the second conductive film.

The fourth invention is a solar cell module according to the first or the second invention, wherein the second base member and the second conductive layer formed on the surface of the second base member are metallic plates.

According to the above-described configuration, since the counter electrode substrate is made of a metallic plate, it is possible to reduce the electric resistance of the counter electrode substrate. In addition, the configuration of the counter electrode substrate becomes simple.

The fifth invention is a solar cell module according to any of the first through the fourth inventions, wherein the conductive member is a metallic plate or a metallic tape.

According to the above-described configuration, locating the metallic plate or metallic tape so as to keep in contact with the exposed portion of the first conductive layer of the first solar cell and the exposed portion of the second conductive layer of the second solar cell is only required, the number of the processes is decreased. In addition, since the metallic plate or metallic tape is easy to obtain, the manufacturing cost decreases.

The sixth invention is a solar cell module according to any of the first through the fourth inventions, wherein the coupling member is an insulation tape adhered so as to cover a connecting line between the substrates of the first solar cell and the second solar cell.

According to the above-described configuration, adhering the insulation tape so as to cover the connecting line between the substrates of the first solar cell and the second solar cell is only required. As a result, since it is possible to couple the solar cell module without making a special processing to the substrate, the number of the processes is decreased.

The seventh invention is a method of manufacturing a solar cell module made of at least two dye-sensitized solar cell coupled with each other. Each of the solar cells comprises:
a photoelectrode substrate including a first base member, and a first conductive layer and a photoelectrode layer sequentially formed on one surface of the first base member;
a counter electrode substrate including a second base member, and a second conductive layer formed on one surface of the second base member, the counter electrode substrate being located with a certain space from the photoelectrode substrate so as to face the surface on which the first conductive layer is formed, and the counter electrode substrate being displaced from the photoelectrode substrate such that an exposed portion of the first conductive layer and an exposed portion of the second conductive layer are defined; and
a charge conveyance layer provided in the certain space.

The method comprises steps of:
disposing a conductive member on the exposed portion of the first conductive layer or the exposed portion of the second conductive layer of a first solar cell;
locating a second solar cell such that the exposed portion of the second conductive layer or the exposed portion of the first conductive layer of the second solar cell is overlapped with the disposed conductive member; and
coupling the first solar cell with the second solar cell by a coupling member such that the conductive member keeps in contact with the exposed portions of the first solar cell and the second solar cell.

According to the above-described configuration, since the conductive adhesive becomes unnecessary for coupling the solar cell module, the electric resistance between the solar cells is lowered. In addition, since the processes of pasting and curing the conductive adhesive becomes unnecessary, the number of the processes is decreased.

### EFFECT OF THE INVENTION

According to the present invention, in the solar cell module having at least two dye-sensitized solar cells coupled with each other, the electric resistance between the solar cells is lowered, thereby providing a solar cell module having excellent conversion efficiency.

### BRIEF DESCRIPTION OF DRAWINGS

Fig. 1 (1) is a perspective view showing the general configuration of the solar cell module according to the first embodiment of the present invention. Fig. 1 (2) is a view showing status of the solar cell module shown in Fig. 1 (1) before the solar cells are coupled with each other.
Fig. 2 is a cross section along I-I line shown in Fig. 1 (1).
Fig.3 is a plane view showing the general configuration of the solar cell seen from the photoelectrode substrate and the counter substrate.
Fig. 4 is a cross section showing the general configuration of the solar cell module according to the second embodiment of the present invention.
Fig. 5 is a cross section and a plane view showing the general configuration of the coupling portion for which another coupling member is used.

### EMBODIMENTS

Next, the embodiments according to the present invention will be explained with reference to the drawings.

### [First Embodiment]

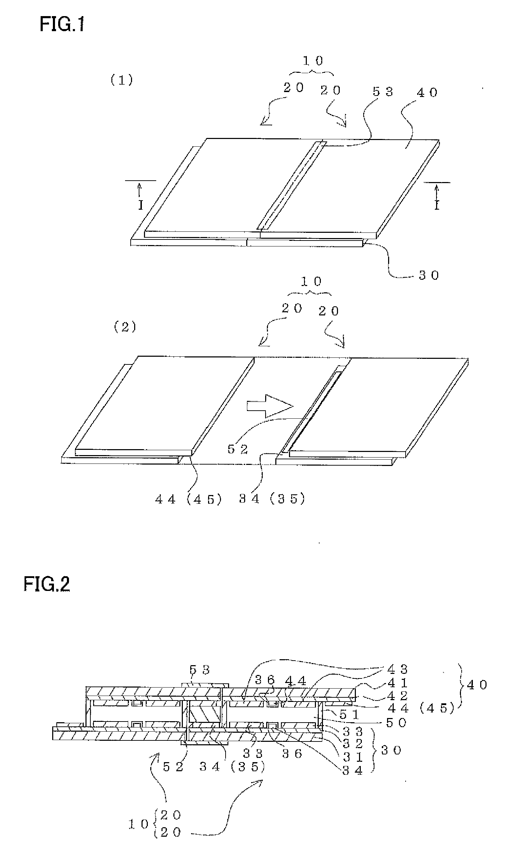

As shown in Fig. 1 (1), a solar cell module 10, according to the first embodiment of the present invention, is configured such that insulation tapes 53 are adhered to a first solar cell 20 and a second solar cell 20 so as to cover a connecting line between photoelectrode substrates 30 and a connecting line between counter electrode substrates 40.

### (1) Solar Cell

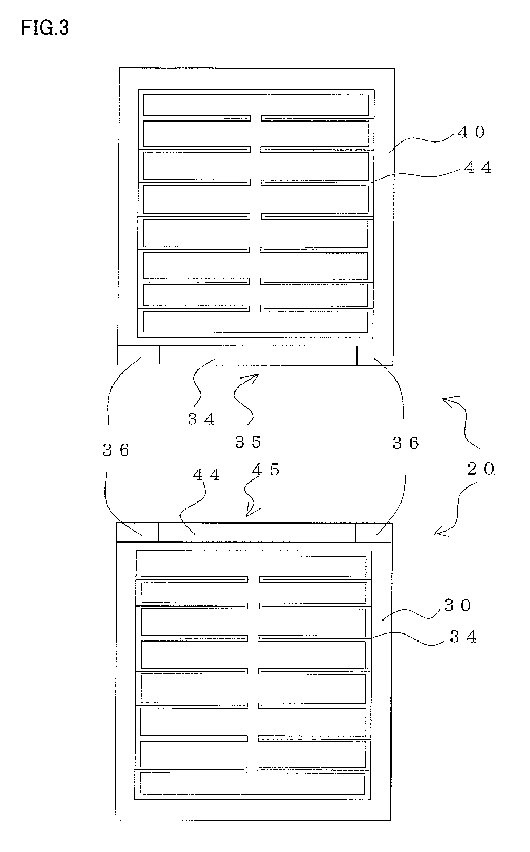

The solar cell 20 will be explained with reference to Fig. 2 and Fig. 3.

The solar cell 20 includes a photoelectrode substrate 30, a counter electrode substrate 40 facing the photoelectrode substrate 30, a charge conveyance layer 50 provided in an area through which the substrates 30, 40 face each other, and a sealant 51 located so as to seal the above-described area.

The photoelectrode substrate 30 is a substrate constituting a light incident surface. The photoelectrode substrate 30 includes a first base member 31, a first conductive film 32, a photoelectrode layer 33 configured to pass a charge generated from the sensitized dye due to the light irradiation, and a first current collecting line 34 configured to efficiently collect electrons. The first conductive film 32 and the photoelectrode layer 33 are sequentially formed on one surface of the first base member 31. The first current collecting line 34 is formed on a portion of the first conductive film 32 where the photoelectrode layer 33 is not formed, e.g., comb-shaped, in order to decrease loss due to the electric resistance. The first conductive film 32 and the first current collecting line 34 constitutes a first conductive layer.

The counter electrode substrate 40 includes a second base member 41, a second conductive film 42, a catalyst layer 43 for improving the power generation efficiency, and a second current collecting line 44 configured to efficiently collect the generated electrons. The second conductive film 42 and the catalyst layer 43 are sequentially formed on one surface of the second base member 41. The second current collecting line 44 is formed, as is the first current collecting line 34, on a portion of the second conductive film 42 where the catalyst layer 43 is not formed, e.g., comb-shaped, in order to decrease the loss due to the electric resistance. The second conductive film 42 and the second current collecting line 44 constitute a second conductive layer. It should be noted that the first current collecting line 34 and the second current collecting line 44 are formed at positions facing each other in order to ensure an area as broad as possible, which will contribute to the generation. In addition, it is preferable that the first current collecting line 34 and the second current collecting line 44 should be covered by an insulation layer 36. The reason is that the insulation layer 36 prevents the corrosion due to the electrolyte, which is the charge conveyance layer 50, and prevents a short circuit between the photoelectrode substrate 30 and the counter electrode substrate 40 through the first current collecting line 34 and the second current collecting line 44.

The counter electrode substrate 40 is located with a certain gap from the photoelectrode substrate 30 such that a surface on which the first conductive layer is formed and a surface on which the second conductive layer is formed face each other, and the counter electrode substrate 40 is located so as to be displaced from the photoelectrode substrate 30 such that the exposed portion of the first conductive layer 35 and the exposed portion of the second conductive layer 45 are defined. The exposed portion of the first conductive layer 35 is made of the first current collecting line 34, and the exposed portion of the second conductive layer 45 is made of the second current collecting line 44.

Next, members constituting the solar cell 20 will be explained.

### First Base Member

The first base member 31 preferably has high transparency because it is a light incident surface, and it can be made of glass having high transparency, tempered glass, synthesized resin having high transparency such as polycarbonate resin, acrylic resin, polyacrylate resin, polymethacrylate, and polyvinyl chloride. Furthermore, in addition to later-described polyethylene terephthalate resin having a high durability against the charge conveyance layer 50, polyester synthetic resin such as polybutylene terephthalate resin and polyethylene naphthalate resin, and polyolefin synthetic resin such as polyethylene, polypropylene, and cyclic polyolefin resin may be properly used.

### First Conductive Film

As a material of the first conductive film 32, there is no limitation only if it has excellent conductivity. It may be made of tin-doped indium oxide (ITO), fluorine-doped tin oxide (FTO), antimony-doped tin oxide (ATO), gold, platinum and so on, and a combination of them. The first conductive film 32 is formed with a vacuum evaporation method, a sputtering method, an ion plating, a CVD method, a migration electrodeposition method and so on.

### Photoelectrode Layer

The photoelectrode layer 33 is formed of the minute particles of metallic oxide that holds the sensitizing dye. It is preferable that the minute particles of metallic oxide should be porous having through holes in order to hold the sensitizing dye.

### First Current Collecting Line and Second Current Collecting Line

As a material of the first current collecting line 34 and the second current collecting line 44, paste including metallic materials such as silver can be used, for example. As the insulation layer 36 covering the first current collecting line 34 and the second current collecting line 44, glass frit or resin can be used. In this case, paste such as glass frit is pasted onto the first current collecting line 34 and the second current collecting line 44, and is burned so as to form the insulation layer 36.

### Second Base Member

The second base member 41 can be formed using the same material as that of the first base member 31.

### Second Conductive Film

The second conductive film 42 may be formed using the same material as that of the first conductive film 32, and with the same method of forming the first conductive film. In addition, when the catalyst layer 43 is formed on the second conductive film 42, as a material for the catalyst layer 43, a layer made of the deposited platinum, organic matters such as polyaniline, polythiophene, and polypyrrole may be used.

### Change Conveyance Layer

The charge conveyance layer 50 may be made of conducting materials that can convey ions. As a suitable material, for example, there are liquid electrolyte, solid electrolyte, and gel electrolyte. The liquid electrolyte have only to be liquid including redox species, and the ones which can be generally used for batteries or solar cells can be used, and is not particularly limited. The solid electrolyte may be conducting materials that can convey electrons, holes, and ions, and that may be used as an electrolyte of the solar cell without liquidity. The gel electrolyte is typically composed of electrolyte and gelling agent, and the above-described solid electrolyte can be used as an electrolyte.

Next, the method of manufacturing the solar cell 20 will be explained.

First, a porous semiconductor layer made of minute particles of metallic oxide is formed on the first conductive film 32, which is formed on one surface of the first base member 31. The sensitizing dye is held by the porous semiconductor layer so as to make the photoelectrode layer 33. Furthermore, paste including metallic materials such as silver is pasted onto a portion of the first conductive film 32 where the photoelectrode layer 33 is not formed, and is burned so as to make the first current collecting line 34. Paste such as glass frit is pasted onto the first current collecting line 34 and is burned so as to make the insulation layer 36. As described above, the photoelectrode substrate 30 is obtained.

Next, the catalyst layer 43 such as a platinum film is coated onto the second conductive film 42 formed on one surface of the second base member 41. Then, as is the first current collecting line 34, paste including metallic materials such as silver is pasted onto a portion of the second conductive film 42 where the catalyst layer 43 is not formed, and is burned so as to form the second current collecting line 44. Paste such as glass frit is pasted on the second current collecting line 44, and is burned so as to form the insulation layer 36. As described above, the counter electrode substrate 40 is obtained.

Next, the photoelectrode substrate 30 and the counter electrode substrate 40 are located such that the surface on which the first conductive film 32 is formed and the surface on which the second conductive film 42 is formed faces each other. At this time, the photoelectrode substrate 30 and the counter electrode substrate 40 are located so as to be displaced from each other such that the exposed portion of the first conductive layer 35 made of the first current collecting line 34 and the exposed portion of the second conductive layer 45 made of the second current collecting line 44 are defined.

The insulation layer 36 is not formed on the first current collecting line 34 and the second current collecting line 44, which constitute the exposed portion of the first conductive layer 35 and the exposed portion of the second conductive layer 45, in order to ensure the conduction with the later-described metallic plate or metallic tape 52. Indeed, as shown in Fig. 3, ends of the first current collecting line 34 and the second current collecting line 44, which constitute the exposed portion of the first conductive layer 35 and exposed portion of the second conductive layer 45, may be covered with the insulation layer 36. The purpose of the above-described structure is to protect the first current collecting line 34 and the second current collecting line 44 from the corrosion due to the electrolyte when the later-described electrolyte is injected through both ends of the exposed portion of the first conductive layer 35 and the exposed portion of the second conductive layer 45.

It should be noted that first current collecting line 34 and the second current collecting line 44 do not necessarily have to be formed if the electric resistance of the first conductive film 32 and the second conductive film 42 is within a permissible limit in terms of product characteristics. In a case where the first current collecting line 34 and the second current collecting line 44 are not formed, the exposed portion of the first conductive layer 35 and the exposed portion of the second conductive layer 45 are constituted by the first conductive film 32 and the second conductive film 42, respectively.

Finally, electrolytes are injected into the area through which photoelectrode substrate 30 and the counter electrode substrate 40 face each other in order to form the charge conveyance layer 50. The side surfaces of the area through which the photoelectrode substrate 30 and the counter electrode substrate 40 face each other is sealed by the sealant 51 such as epoxy resin. It should be noted that if the charge conveyance layer 50 is made of the liquid electrolyte, the sealant 51 is provided to seal the area through which the photoelectrode substrate 30 and the counter electrode substrate 40 face each other in order to prevent the battery leakage of the liquid electrolyte. In contrast, if the solid electrolyte or the gel electrolyte is employed, the sealant 51 does not necessarily have to be formed. As described above, the solar cell 20 is obtained.

### (2) Solar Cell Module

The solar cell module 10, which is made by coupling at least two solar cells 20 made with the above-described manufacturing method, will be explained with reference to Fig. 1, Fig. 2, and Fig. 3.

As shown in Fig. 2, the solar cell module 10 includes the metallic plate or metallic tape 52, as the conductive member which does not have adhesiveness, located so as to keep in contact with the first current collecting line 35 as the exposed portion of the first conductive layer of the first solar cell 20 and the second current collecting line 45 as the exposed portion of the second conductive layer of the second solar cell 20. The solar cell module 10 further includes the insulation tape 53 as the coupling member that couples the first solar cell 20 and the second solar cell 20 such that the metallic plate or metallic tape 52 keeps in contact with them.

The metallic plate or metallic tape 52 is a conductive member that conducts the first solar cell 20 and the second solar cell 20, and it is made of a thin plate-like or band-like metal which does not have adhesiveness. The metallic plate or metallic tape 52 is located such that its one surface keeps in contact with the first current collecting line 35 as the exposed portion of the first conductive layer of the first solar cell 20, and that its another surface keeps in contact with ins the second current collecting line 45 as the exposed portion of the second conductive layer of the second solar cell 20. Since the metallic plate or metallic tape is used, it becomes easy to evenly define the thickness, so that the variation of the electric resistance of the solar cell module 10 will be lost. In addition, since the metallic plate or metallic tape is a material easy to obtain, it is possible to manufacture it at low cost.

The insulation tape 53, as the coupling member, couples the first solar cell 20 with the second solar cell 20. The insulation tape 53 has an adhesive layer on its one surface, and the adhesive layer side is adhered to the surfaces of the solar cells 20, so as to cover the connecting line between the photoelectrode substrates 30 of the first solar cell 20 and the second solar cell 20, and the connecting line between the counter electrode substrates 40 of the first solar cell 20 and the second solar cell 20. Since the insulation tape 53 is used, it is possible to couple the solar cell module by just adhering the first solar cell 20 to the second solar cell 20. Accordingly, it is not necessary to make a special processing to the substrate, thereby decreasing the number of the processes.

It should be noted that although the photoelectrode substrates 30 of the first solar cell 20 and the second solar cell 20 are coupled with each other with a gap and the counter electrode substrates 40 of the first solar cell 20 and the second solar cell 20 are coupled with each other with a gap as shown in Fig. 2, they can be coupled without gaps.

Next, members constituting the solar cell module 10 will be explained.

### Metallic Plate or Metallic Tape

Materials of the metallic plate or metallic tape 52, as the conductive member which does not have adhesiveness, may be various metals such as copper, aluminum, and iron. The thickness of the metallic plate or metallic tape 52 is preferably the same as a gap between the photoelectrode substrate 30 and the counter electrode substrate 40. If the thickness is larger than the gap, it is impossible to couple the first solar cell 20 with the second solar cell 20 so as to be flush with each other. The metallic plate or metallic tape 52 can be formed so as to have a thickness of 50 to 200 µm, for example, so as to correspond to the gap between the photoelectrode substrate 30 and the counter electrode substrate 40.

In addition, length and width of the metallic plate or metallic tape 52 only have to be within the exposed portion of the first conductive layer 35 and the exposed portion of the second conductive layer 45, i.e., they are not particularly limited. As shown in Fig. 3, in order to prevent the corrosion due to the injection of the electrolyte, in a case where the insulation layer 36 covers both ends of the first current collecting line 34 as the exposed portion of the first conductive layer 35 and the second current collecting line 44 as the exposed portion of the second conductive layer 45, the metallic plate or metallic tape 52 is formed so as to have a length which rests within a portion where the insulation layer 36 is not formed.

### Insulation Tape

The material of the insulation tape 53 is only have to be an adhesive tape having insulation, and is not particularly limited. An adhesive tape can be employed that includes a base member made of polyimide film, epoxy film, polytetrafluoroethylene film, polyester film, glass cloth and so on, and an adhesive layer layered on the base member, made of acrylic adhesive, heat curing type silicone adhesive, heat curing type rubber adhesive, and so on. Since the insulation material is employed, it is possible to surely prevent a short circuit between the photoelectrode substrates 30 of the first solar cell 20 and the second solar cell 20, and a short circuit between the counter electrode substrates 40 of the first solar cell 20 and the second solar cell 20.

It is preferable to form the width of the insulation tape 53 such that the insulation tape 53 is not overlapped with the photoelectrode layer 33 when disposed, thereby not impeding the power generation.

Next, with reference to Fig. 1 (2), a method of manufacturing the solar cell module 10 having the two solar cells 20 coupled with each other will be explained.

First, two solar cells 20 are prepared. Regarding the first solar cell 20, the metallic plate or metallic tape 52 is disposed such that its one surface gets into contact with the first current collecting line 34 as the exposed portion of the first conductive layer 35. It should be noted that although the metallic plate or metallic tape 52 is disposed on the first current collecting line 34 as the exposed portion of the first conductive layer 35 in Fig. 1 (2), the metallic plate or metallic tape 52 may be disposed on the second current collecting line 44 as the exposed portion of the second conductive layer 45.

Next, the first current collecting line 34 as the exposed portion of the first conductive layer 35 or the second current collecting line 44 as exposed portion of the second conductive layer 45 of the first solar cell 20 on which the metallic plate or metallic tape 52 is placed, is overlapped with the second current collecting line 44 as the exposed portion of the second conductive layer 45 or the first current collecting line 34 as the exposed portion of the first conductive layer 35 of the second solar cell 20, via the metallic plate or metallic tape 52. Accordingly, another surface of the metallic plate or metallic tape 52 of the first solar cell 20 keeps in contact with the second current collecting line 44 as the exposed portion of the second conductive layer 45 or the first current collecting line 34 as the exposed portion of the first conductive layer 35, which ensures conduction between the first solar cell 20 and the second solar cell 20.

Finally, the insulation tape 53 is adhered so as to cover the connecting line between the photoelectrode substrates 30 of the two solar cells 20, and the connecting line between the counter electrode substrates 40 of the two solar cells 20, such that both surfaces of the metallic plate or metallic tape 52 keeps in contact with the first current collecting line 34 as the exposed portion of the first conductive layer 35 or the second current collecting line 44 as the exposed portion of the second conductive layer 45 of the first solar cell 20, and the second current collecting line 44 as the exposed portion of the second conductive layer 45 or the first current collecting line 34 as the exposed portion of the first conductive layer 35 of the second solar cell 20. As described above, the solar cell module 10 is obtained. When three or more solar cells 20 are to be coupled with each other, the above-described method can be employed.

Accordingly, regarding the solar cell module 10 manufactured with the above-described method, the conductive adhesive is not used for coupling the solar cell module 10. Accordingly, the electric resistance between the first solar cell 20 and the second solar cell 20 is decreased. Furthermore, since the processes of pasting and curing the conductive adhesive become unnecessary, the number of the processes is decreased and the manufacturing becomes easy.

### [Second embodiment]

In the solar cell module 10 according to the second embodiment of the present invention, the second base member 41 and the second conductive film 42, which is the second conductive layer, is composed of one member having conductivity, and may be composed of various metallic plates such as titanium and aluminum.

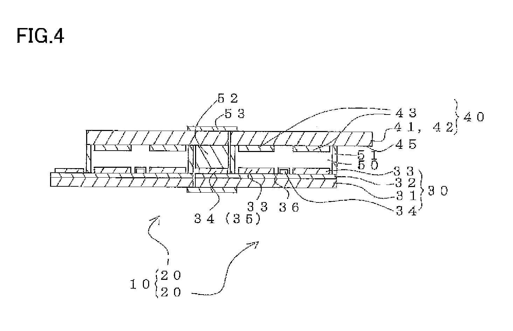

As shown in Fig. 4, metallic plates used for the second base member 41 and the second conductive film 42, which is and the second conductive layer, are made of a material having low electric resistance. Therefore, it is not necessary to form the second current collecting line 44. Accordingly, the second base member 41 and the second conductive film 42, which is and the second conductive layer, constitute the exposed portion of the second conductive layer 45.

In addition, in the solar cell module 10 according to the second embodiment of the present invention, it is necessary to couple the first solar cell 20 with the second solar cell 20 with a gap therebetween. The purpose of the above-described structure is to prevent a short circuit between the counter electrode substrates 40 of the first solar cell 20 and the second solar cell 20 due to the contact.

It should be noted that the same numerals are assigned to constituent elements the same as the constituent elements shown in Fig. 2. In addition, the explanation redundant with the constituent elements of the solar cell 20 and the method of manufacturing the solar cell module 10 shown in Fig. 2 will be omitted.

It should be noted that although the metallic plate or metallic tape 52 is employed as the conductive member in the first embodiment and the second embodiment, the shape of the conductive member is not limited to a thin plate or band. A thread metallic wire can be employed, for example.

Although the insulation tape 53 is employed as the coupling member in the first embodiment and the second embodiment, the coupling member is not limited to the insulation tape 53. A member that can couple the substrates of the solar cells 20 is a coupling member according to the present invention.

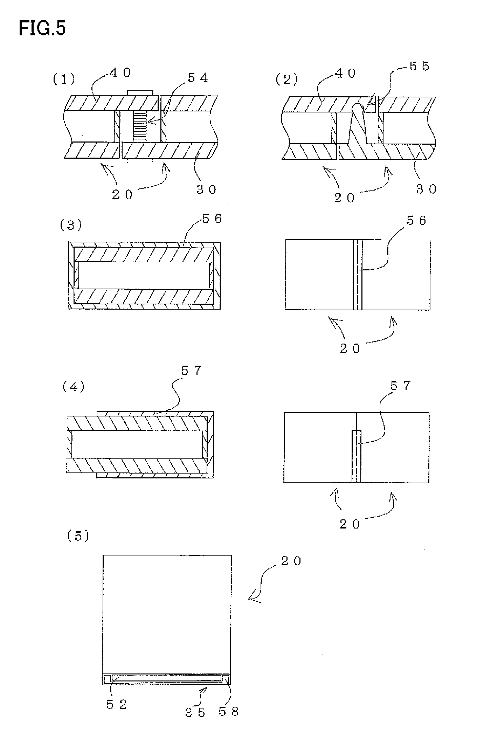

For example, as shown in Fig. 5 (1), screw holes may be formed on the photoelectrode substrate 30 and the counter electrode substrate 40, and a screw and nut 54 may be used for the coupling. In another example, as shown in Fig. 5 (2), engaging portions 55, made of a convex portion and a concave portion, may be formed on the photoelectrode substrate 30 of the first solar cell 20 and the counter electrode substrate 40 of the second solar cell 20, and they may be engaged with each other. In this case, the convex portion and the concave portion may be either formed on the photoelectrode substrate 30 of the first solar cell 20 or the counter electrode substrate 40 of the second solar cell 20. In addition, as shown in Fig. 5 (3), the substrates of the first solar cell 20 and the second solar cell 20 may be coupled by an annular band 56. As shown in Fig. 5 (4), instead of the band 56, a U-shaped clip 57 may be used. In addition, as shown in Fig. 5 (5), a glass ribbon 58 having a thickness of several tens µm may be located around the metallic plate or metallic tape 52 disposed on the exposed portion of the first conductive layer 35 of the first solar cell 20. The glass ribbon 58 is heated and deposited to couple the first solar cell 20 with the second solar cell 20. In this case, the glass ribbon 58 can be replaced with adhesive. It should be noted that although the metallic plate or metallic tape 52 is disposed on the exposed portion 34 of the first conductive layer of the first solar cell 10 and the glass ribbon 58 is disposed around the metallic plate or metallic tape 52 in Fig. 5 (5), if the metallic plate 52 is disposed on the exposed portion of the second conductive layer 45, the glass ribbon 58 will be also disposed on the exposed portion of the second conductive layer 45.

### DESCRIPTION OF REFERENCE SIGNS

- 10: solar cell module
- 20: solar cell
- 30: photoelectrode substrate
- 31: first base member
- 32: first conductive film
- 33: photoelectrode layer
- 34: first current collecting line
- 35: exposed portion of first conductive layer
- 36: insulation layer
- 40: counter electrode substrate
- 41: second base member
- 42: second conductive film
- 43: catalyst layer
- 44: second current collecting line
- 45: exposed portion of second conductive layer
- 50: charge conveyance layer
- 51: sealant
- 52: metallic plate or metallic tape
- 53: insulation tape
- 54: screw and nut
- 55: engaging portion
- 56: band
- 57: clip
- 58: glass ribbon

## Claims

1. A solar cell module comprising at least two dye-sensitized solar cells coupled with each other,
each of the solar cells comprises:
a photoelectrode substrate including a first base member, and a first conductive layer and a photoelectrode layer sequentially formed on one surface of the photoelectrode substrate;
a counter electrode substrate including a second base member and a second conductive layer formed on one surface of the second base member, the counter electrode substrate being located with a certain space from the photoelectrode substrate so as to face the surface on which the first conductive layer is formed, and the counter electrode substrate being located to be displaced from the photoelectrode substrate such that an exposed portion of the first conductive layer and an exposed portion of the second conductive layer are defined; and
a charge conveyance layer provided in the certain space,
the solar cell module further comprising:
a conductive member which does not have adhesiveness, the conductive member being located so as to keep in contact with the exposed portion of the first conductive layer of a first solar cell and the exposed portion of the second conductive layer of a second solar cell; and
a coupling member coupling the first solar cell with the second solar cell such that the conductive member keeps in contact with the exposed portions.

2. The solar cell module according to claim 1, wherein the first conductive layer includes a first conductive film, and a first current collecting line formed on a portion of the first conducive film where the photoelectrode layer is not formed, and
the exposed portion of the first conductive layer is made of the first current collecting line.

3. The solar cell module according to claim 1 or 2, wherein the second conductive layer includes a second conductive film, and a second current collecting line formed on the second conductive layer, and
the exposed portion of the second conductive layer is made of the second current collecting line.

4. The solar cell module according to claim 1 or 2, wherein the second base member and the second conductive layer formed on the one surface of the second base member are metallic plates.

5. The solar cell module according to any of claims 1 through 4, wherein the conductive member is a metallic plate or a metallic tape.

6. The solar cell module according to any of claims 1 through 4, wherein the coupling member is an insulation tape adhered so as to cover a connecting line between the substrates of the first solar cell and the second solar cell.

7. A method of manufacturing a solar cell module having at least two dye-sensitized solar cells connected with each other, wherein
each of the solar cells comprises:
a photoelectrode substrate including a first base member, and a first conductive layer and a photoelectrode layer sequentially formed on one surface of the first base member;
a counter electrode substrate including a second base member, and a second conductive layer formed on one surface of the second base member, the counter electrode substrate being located with a certain space from the photoelectrode substrate so as to face the surface on which the first conductive layer is formed, and being displaced from the photoelectrode substrate such that an exposed portion of the first conductive layer and an exposed portion of the second conductive layer are defined; and
a charge conveyance layer provided in the certain space,
the method comprising steps of:
disposing a conductive member on the exposed portion of the first conductive layer or the exposed portion of the second conductive layer of a first solar cell;
locating a second solar cell such that the exposed portion of the second conductive layer or the exposed portion of the first conductive layer of the second solar cell is overlapped with the disposed conductive member; and
coupling the first solar cell with the second solar cell by a coupling member such that the conductive member keeps in contact with the exposed portions of the first solar cell and the second solar cell.
